# EUROPEAN PATENT SPECIFICATION

(11) **EP 1 327 301 B1**
(45) Date of publication and mention of the grant of the patent: **19.12.2007**
(21) Application number: 01976282.2
(22) Date of filing: 05.10.2001
(51) Int. Cl.: H03G 3/30

(54) **AMPLIFICATION CIRCUIT WITH IMPROVED LINEARITY**
VERSTÄRKERSCHALTUNG MIT HOHER LINEARITÄT
CIRCUIT D'AMPLIFICATION AVEC UNE LINEARITE AMELIOREE

(30) Priority: 10.10.2000 FR 0012938
(43) Date of publication of application: 16.07.2003
(73) Proprietor: NXP B.V., 5656 AG Eindhoven (NL)
(72) Inventor: CONSTANTINIDIS, Nicolas, NL-5656 AA Eindhoven (NL); CRINON, Guillaume, NL-5656 AA Eindhoven (NL)
(74) Representative: White, Andrew Gordon
(86) International application number: PCT/EP2001/011600
(87) International publication number: WO 2002/031972

(56) References cited:
- WO-A-98/43348
- US-A- 5 872 481
- US-A- 6 094 099

## Description

The invention relates to an amplification circuit having an overall gain which varies continuously as a function of the value of the control signal.

Such an amplification circuit is described in patent application WO 98/43348. In the known amplification circuit, variations of the control signal cause variations of a current originating from a current source controlled by the control signal. As this current is used to bias a PIN-type diode, said diode has an impedance that varies as a function of the control signal, enabling a variation in overall gain of the amplification circuit, which is representative of a ratio between the amplitudes of output signals and input signals of the amplification circuit.

The circuit in accordance with the prior art has a number of drawbacks. First of all, the PIN-type diode cannot readily be manufactured in integrated form, which implies that the amplification circuit cannot readily be manufactured in the form of a single integrated circuit. Furthermore, when the control signal has a large variation range, the variation of the impedance of the diode, and hence the variation of the overall gain of the amplification circuit, is not linear for the whole variation range. In that case, non-linearity of the gain of the amplification circuit will lead to an uncontrolled distortion in the output signal of the amplification circuit.

In addition, when the amplification circuit is used to regulate the amplitude of a signal, i.e. when its overall gain is properly readjusted by means of a servo-control system, the non-linear behavior of the PIN-type diode causes a distortion to be introduced into the output signal of the amplification circuit, which distortion varies as a function of the amplitude of the input signal. To attenuate the effects of such a distortion, an amplification chain comprising the known amplification circuit generally includes, upstream of said circuit, a preset filter, which serves to remove parasitic harmonics from the input signal of the amplification circuit, and an amplifier to compensate for the power losses caused by the preset filter, as a result of which the operation of said amplification circuit is both complex and expensive.

US-A-6 094 099 describes a gain control circuit for a so-called distributed amplifier with various differential amplifier stages. The distributed amplifier has transistor current source switches for each differential amplifier stage in order to control offset voltages of each differential amplifier stage.

US-A 5 872 481 describes an amplifier circuit that comprises a plurality of amplifier stages. A control circuit selectively activates one or more amplifier stages that are necessary to provide a desired level of output power.

US-A 5 930 696 discloses a combination of a voltage/current converter and a differential automatic gain control amplifier that can be employed in a receiver system.

EP-A EP 0 876 004 describes a gain controller that comprises a distributor for applying an input signal to two paths, each of which includes a gain control amplifier. A mixer mixes respective output signals of the two paths with each other. A control circuit separately controls respective gains of the gain control amplifiers in the two paths.

It is an object of the invention to substantially overcome the drawbacks mentioned in relation with WO 98/43348 by providing an integrable amplification circuit whose overall gain varies in a quasi-linear manner as a function of the control signal, and which circuit causes only a small, substantially constant distortion to be introduced according to the amplitude of the input signal of the amplification circuit.

Claim 1 defines an amplification circuit in accordance with the invention.

In accordance with the invention, the variation range of the overall gain of the amplification circuit is divided into as many zones as there are amplification branches in the circuit, and each amplification branch can be designed such that the variation of its gain proper is quasi-linear in the part of the variation range for which said branch makes the largest contribution to the overall gain.

In addition, as each branch can be optimized so as to introduce the smallest possible distortion into the output signal of the amplification circuit in the zone where said branch makes the largest contribution to the overall gain, the distortion introduced by the amplification circuit is known and properly controlled irrespective of the value of the overall gain.

The invention can be utilized in every application where amplification or attenuation of a signal is required. In a device for receiving radioelectric signals, for example a television receiver, a decoder unit or a radiotelephone, the power of the signal received may vary considerably as a function of various parameters, such as the distance between the receiver and the emission source, or also the position of an antenna system with respect to said emission source. The device includes chains for processing the signal received, which are dimensioned so as to be suitable for a given power of said signal, and hence said device will be advantageously provided with a system for regulating the power of the signal received, said system being capable of amplifying or attenuating said signal so as to adapt said signal to the chains before processing the signal.

Claim 4 defines a device for receiving radioelectric signals in accordance with the invention.

The quasi-linear development of the gain of the amplification circuit as a function of the control signal, obtained by virtue of the invention, enables to omit preselection filters and associated amplifiers, which are usually arranged upstream of the amplification circuit. This leads to a substantial simplification of the structure of the receiver, and to a reduction of its production cost, which can be attributed to the fact that the amplification circuit in accordance with the invention can be manufactured so as to be an integrated circuit. These and other aspects of the invention will be apparent from and elucidated with reference to the non-limitative exemplary embodiment and the annexed drawings, wherein:
Fig. 1 is a block diagram of an amplification circuit in accordance with a particular embodiment of the invention,
Fig. 2 is an electrical wiring diagram of voltage dividers included in such an amplification circuit,
Fig. 3 is an electrical wiring diagram of amplification branches in accordance with a preferred embodiment of the invention,
Fig. 4 shows a group of curves showing, in particular, the development of the overall gain of an amplification circuit in accordance with the invention,
Fig. 5 shows a group of curves showing, in particular, the development of the linearity of an amplification circuit in accordance with the invention, and
Fig. 6 is a block diagram of a receiver in accordance with an embodiment of the invention.

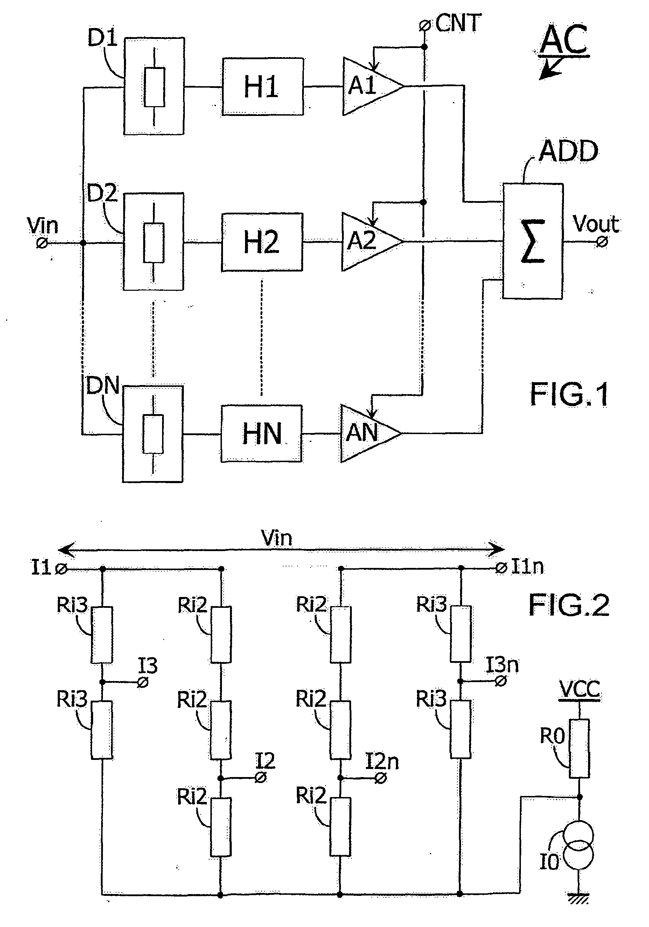

Fig. 1 shows a particular embodiment of an amplification circuit AC, which is intended to receive an input signal Vin and issue an output signal Vout. This amplification circuit comprises a plurality of amplification branches (Di, Hi, ai, where i = 1 to N), each amplification branch having a gain proper which makes a contribution to the overall gain of the amplification circuit AC, the size of said contribution being determined by a control signal CNT.

The amplification branches are intended to receive an identical input signal Vin and comprise a so-called transfer circuit Hi and an amplifier Ai which are arranged in cascade, the control signal CNT being capable of controlling the gain of said amplifier Ai. The amplification circuit AC additionally comprises an adder ADD which is intended to receive the output signals from the amplification branches. Vout can then be expressed as follows: Vout = Σ(ai.hi(Vin)), where hi(Vin) represents the transfer function of a transfer circuit Hi where i = 1 to N, and ai is the gain of an amplifier Ai. Each transfer function can be expressed by the equation hi(Vin) = bi.Vin+ci.(Vin)³. The inventors have found that the linearity LIN of the amplification circuit AC, which is defined so as to be equal to the ratio between the variations in amplitude of the output and input signals Vout and Vin, respectively, can be expressed as follows: LIN = ΔVout/ΔVin = [Σ(ai.bi)]/[Σ(ai.(bi)⁴], taking into consideration that the contribution by the (Vin)³ terms is negligibly small as compared to the Vin terms, the amplitude of the signal Vin being much smaller than unity.

By judiciously choosing the parameters ai and bi, it thus becomes possible to optimize the linearity of the amplification circuit AC. In the amplification circuit shown in Fig. 1, the amplification branches additionally comprise voltage dividers Di, where i = 1 to N. These voltage dividers serve two purposes: they enable, on the one hand, a constant input impedance of the amplification circuit AC to be obtained as they can be advantageously embodied so as to be resistance bridges. On the other hand, they provide additional freedom in terms of the dimensions of the amplification branches, enabling the linearity of the amplification circuit AC to be optimized. The linearity LIN of the amplification circuit AC provided with the voltage dividers Di (where i = 1 to N) can be expressed by the following equation: LIN = [Σ(ai.bi/di)]/[Σ(ai.(bi)⁴/(di)³], where di is the ratio of the division carried out by the divider Di. In an embodiment wherein the amplification circuit AC is intended to carry out a linear attenuation as a function of its input signal, it is possible to choose, if said amplification circuit AC comprises three amplification branches, i.e. N = 3, the following dimensions:
- d1 = 1; d2 = 3; d3 = 2,
- b1 = 0.75; b2 = 0.75; b3 = 0.25, and
- a1 and a2 vary between 0 and 1 as a function of the value of the control signal CNT, whereas a3 is set at 1.

The fact that aN = 1 enables the variation range of the overall gain of the amplification circuit to be controlled. This overall gain, expressed in dB, is equal to 20.1og(Vout/Vin) and will range between 20.log(b3/d3), when a1 = a2 = 0, and 20.log[(b3/d3)+(b2/d2)+(b1/d1)], when a1 = a2 = 1, i.e. in this example between-18 and 1 dB.

It will be obvious that many different embodiments are possible and that the dimensions will each time be selected as a function of the intended application of the amplification circuit. For a better understanding of the above, a description will be given, hereinafter, of a single embodiment enabling the above-mentioned numerical values to be obtained.

Fig. 2 shows voltage dividers included in an amplification circuit whose dimensions are in conformity with those described hereinabove.

In this embodiment, the input signal Vin is naturally differential. The voltage divider D1, with the ratio d1 = 1, does not really exist. Its input signal (I1, I1n) also constitutes its output signal.

The voltage divider D2, with the ratio d2 = 3, comprises two divider bridges, which are each composed of three resistors Ri2, which are arranged in series between an input terminal (I1, I1n) and a reference voltage terminal. Output terminals (I2, I2n) of the voltage divider D2 will deliver a differential signal whose amplitude will be equal to one third of the amplitude of the input signal Vin.

The voltage divider D3, with the ratio d3 = 2, comprises two divider bridges, each bridge being composed of two resistors Ri3, which are arranged in series between an input terminal (I1, I1n) and a reference voltage terminal. Output terminals (I3, I3n) of the voltage divider D3 will supply a differential signal whose amplitude will be half the amplitude of the input signal Vin.

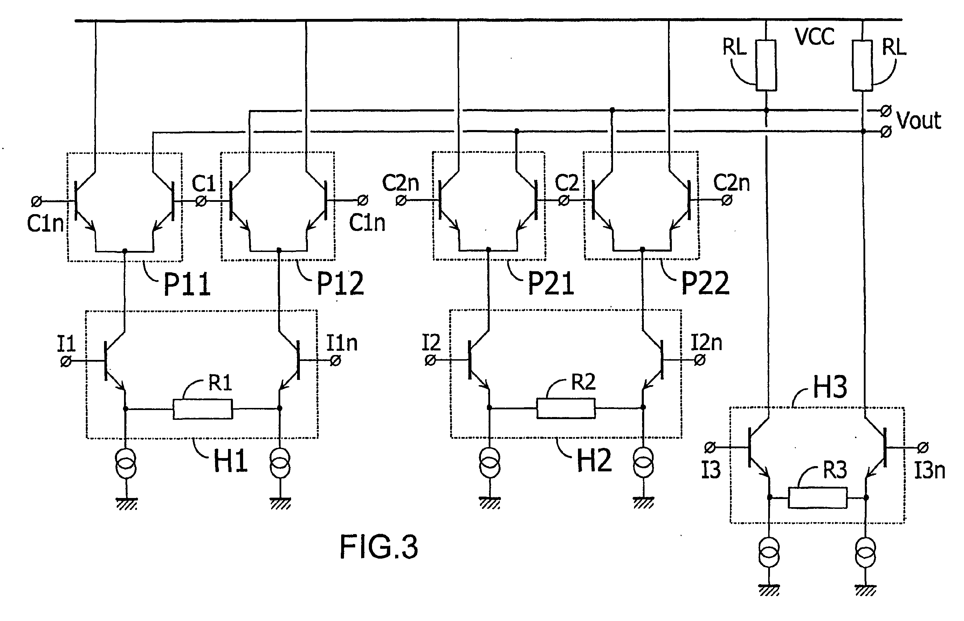

Fig. 3 shows transfer circuits and amplifiers included in an amplification circuit having the dimensions described hereinabove. In this embodiment of the invention, each transfer circuit Hi includes a voltage/current converter in the form of a long-tail pair which is degenerated by means of a resistor Ri, the conduction of said long-tail pair being controlled by means of the signal taken from the output terminals (Ii, Iin) of the voltage divider Di situated upstream of the transfer circuit Hi.

In this case, the adder takes the form of load resistors RL, which are connected to the transfer circuit H1 and are intended to be traversed by currents originating from the different amplification branches and to thus generate a signal and a voltage Vout representative of the sum of the contributions made by each amplification branch.

The first and second amplification branches are each provided with an amplifier formed by two long-tail pairs Pi1 and Pi2, where i = 1 or 2, the conduction of which is controlled by a differential voltage derived from the control signal and applied to the input terminals Ci and Cin of said long-tail pair.

These long-tail pairs are used to direct currents generated by the transfer circuits H1 and H2 towards the load resistors RL. In this preferred embodiment in accordance with the invention, the transfer circuits H1, H2 and the amplifiers (P11, P12) and (P21, P22) thus form Gilbert cells.

In the third amplification branch, the transfer circuit H3 is directly connected to the adder in the form of load resistors RL, as a result of which a3 = 1 and the variation amplitude of the overall gain of the amplification circuit is determined by the gain of the transfer circuit H3.

To respect the dimensions described hereinabove, advantageously the following choice is made:
R1 = 8.RL/3 to obtain b1 = 0.75,
R2 = 8.RL/3 to obtain b2 = 0.75 and
R3 = 8.RL to obtain b3 = 0.25.

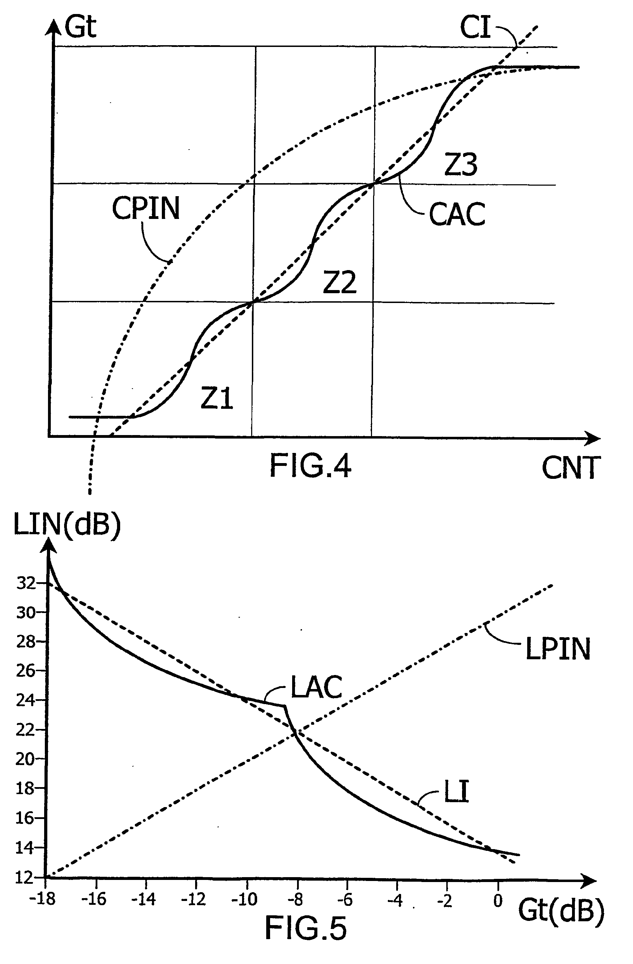

Fig. 4 shows the development of the overall gain Gt of an amplification circuit in accordance with the invention. This development is represented by a curve indicated by means of a continuous line CAC.

A straight, dashed line CI shows the ideal development of the overall gain Gt as a function of the control signal CNT in a perfectly linear amplification circuit. Another curve CPIN shows, by means of a dot-dash line, the development of the overall gain of a known amplification circuit as a function of its control signal.

It is clearly visible that the curve CPIN of the known amplification circuit deviates substantially from the straight line CI, which can be attributed to the non-linear development of the impedance of the PIN-type diode as a function of its polarizing current. Furthermore, the Figure also shows that small variations of the low values of the control signal CNT may cause large variations of the overall gain of the known amplification circuit, wherein, consequently, the overall gain is poorly controlled at low values of the control signal CNT.

The development of the overall gain of the amplification circuit in accordance with the invention can be broken down into three zones Z1, Z2, Z3, the contribution characteristic of each amplification branch H1, H2, H3 to the overall gain Gt being preponderant in each one of said zones.

As each amplification branch is dimensioned so as to present a gain proper with a quasi-linear development in the zone (Zi) where its contribution is largest, the drawing shows that the curve CAC is very close to the straight line CI.

Thus, in the signal amplified by the amplification circuit in accordance with the invention substantially no distortion, generated by non-linear variations of the overall gain Gt as a function of the control signal CNT, is introduced by said amplification signal. Furthermore, the drawing also shows that the variation of the overall gain Gt is small, so that said gain is properly controlled at both small and large values of the control signal CNT.

Fig. 5 shows, by means of a solid-line curve, the development of the linearity LIN, expressed in decibels, of an amplification circuit, as described hereinabove, as a function of the variations of the overall gain Gt expressed in decibels. This curve shows two concavities, each concavity being caused by one of the amplification branches that is not directly connected to the adder.

A straight line LI, indicated by means of a dotted line, shows the linearity of an ideal amplification circuit. This straight line has a gradient of-1 dB/dB, the amplification circuit functioning as a variable attenuator in this example. At a constant amplitude of the output signal Vout, when the amplitude of the input signal Vin is large, the distortion introduced by the amplification signal into its output signal Vout must be small. For this reason, the linearity LIN, which is representative of the ratio ΔVout/ΔVin expressed in decibels, must be high at the low values of the overall gain Gt and decrease as the overall gain Gt increases, the distortion remaining constant as the amplitude of the input signal increases.

A straight line LPIN, indicated by means of a dot-dash line, shows how the linearity of the known amplification circuit develops when use is made of a PIN-type diode. The drawing shows that the gradient of this straight line and the gradient of the straight line LI are of opposite sign, which means that the known amplification circuit cannot suitably be used for the application described hereinabove because it introduces a high distortion for the small values of the overall gain Gt, the value of the distortion introduced by the known amplification circuit additionally increasing as the amplitude of its input signal increases.

The drawing shows, on the other hand, that the curve LAC is adjacent to the straight line LI, which means that the distortion introduced by the amplification circuit in accordance with the invention is small and properly controlled as it is substantially constant as a function of the variations of the input signal.

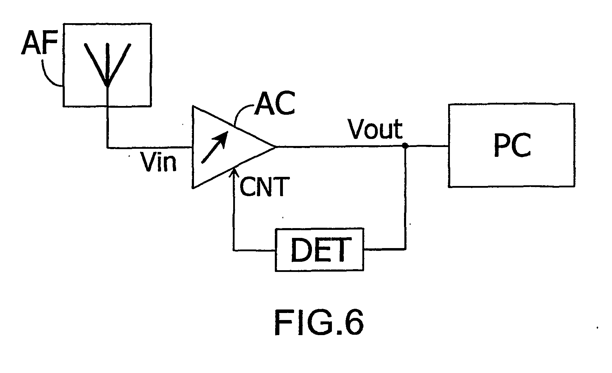

Fig. 6 shows a device for receiving radioelectric signals in accordance with an embodiment of the invention. This device, which may be, for example, a television receiver, a decoder or even a radiotelephone, comprises:
- an antenna system AF for receiving a signal and transforming it to an electronic signal Vin, commonly referred to as radio signal,
- an amplification circuit AC as described hereinabove, which is intended to supply an amplified radio signal Vout,
- a power detector DET intended to supply a control signal CNT to the amplification circuit AC, which control signal is representative of a comparison between the value of the power of the amplified radio signal Vout and a reference value, and
- a signal-processing chain PC intended to exploit the amplified radio signal Vout.

The power detector can be used, for example, to compare the amplitude of the amplified signal Vout with the amplitude of a reference signal, the power of a signal being proportional to the average value of the square of its amplitude.

The invention enables the power of the signal Vout to be regulated, which signal is intended to be exploited by the processing chain of the signal PU, however, without substantially disturbing this signal in an unpredictable manner. Thus, it is not necessary to include, upstream of the amplification circuit, precautionary systems such as preselection filters, leading to a substantial simplification of the internal structure of the device and to a reduction of the production costs. In addition, as the amplification circuit AC does not employ a PIN-type diode, the circuit may be produced inside an integrated circuit, which may also comprise the detector DET and the processing chain of the signal PC.

## Claims

1. An amplification circuit (AC) having an overall gain (Gt) that varies continuously as a function of the value of a control signal (CNT), which amplification circuit comprises:
- a plurality of controllable amplification branches (D1, H1, A1; D2, H2, A2;..) coupled to receive an identical input signal (Vin), each controllable amplification branch having a proper gain that makes a contribution to the overall gain, the size of the contribution being determined by the control signal,
- an adder (ADD) coupled to receive respective output signals from the amplification branches,
**characterized in that** the controllable amplification branches each comprise:
- a transfer circuit (H1; H2, ..) for generating a current on the basis of the identical input signal;
- a long-tail pair (P11, P12; P21, P22) for directing the current generated by the transfer circuit towards a load resistor (RL) that forms part of the adder, the long-tail pair having a conduction that is controlled by a differential voltage derived from the control signal and applied to input terminals (C1, C1n; C2, C2n) of the long-tail pair.

2. An amplification circuit as claimed in claim 1, wherein the transfer circuit (H1; H2, ..) and the long-tail pair (P11, P12; P21, P22) included in an amplification branch jointly form a Gilbert cell.

3. An amplification circuit as claimed in claim 1, wherein at least one amplification branch (D1, H1, A1; D2, H2, A2; ..) comprises a voltage divider (D1; D2; ..) arranged upstream of the transfer circuit (H1; H2, ..).

4. A device (AF, AC, DET, PC) for receiving radioelectric signals, comprising:
- an antenna system (AF) for receiving such a signal and transforming the signal into an electronic signal (Vin), commonly referred to as radio signal,
- an amplification circuit (AC) as claimed in claim 1 for supplying an amplified radio signal (Vout),
- a power detector (DET) for providing a control signal (CNT) to the amplification circuit, which control signal is representative of a comparison between the value of the power of the amplified radio signal and a reference value, and
- a signal-processing chain (PC) for processing the amplified radio signal.

## Patentansprüche

1. Verstärkerschaltung (AC) mit einem Gesamtverstärkungsfaktor (Gt), der sich als Funktion des Wertes eines Steuersignals (CNT) kontinuierlich ändert, wobei die Verstärkerschaltung umfasst:
eine Vielzahl steuerbarer Verstärkungszweige (D1, H1, A1; D2, H2, A2; ...), die verbunden sind, um ein identisches Eingangssignal (Vin) zu empfangen, wobei jeder steuerbare Verstärkungszweig einen geeigneten Verstärkungsfaktor aufweist, der einen Beitrag zum Gesamtverstärkungsfaktor liefert, wobei die Größe des Beitrags vom Steuersignal bestimmt wird,
einen Addierer (ADD), der verbunden ist, um entsprechende Ausgangssignale von den Verstärkungszweigen zu empfangen;
**dadurch gekennzeichnet, dass** die steuerbaren Verstärkungszweige jeweils umfassen:
eine Übertragungsschaltung (H1; H2, ...) zum Erzeugen eines Stroms auf der Grundlage des identischen Eingangssignals;
einen Differenzverstärker (P11, P12; P21, P22) zum Leiten des von der Übertragungsschaltung erzeugten Stroms in Richtung zu einem Lastwiderstand (RL), der einen Teil des Addierers bildet, wobei der Differenzverstärker ein Leitvermögen aufweist, das von einer Differenzspannung gesteuert wird, die aus dem Steuersignal abgeleitet wird und an den Eingangsanschlüssen (C1, C1n; C2, C2n) des Differenzverstärkers anliegt.

2. Verstärkerschaltung nach Anspruch 1, wobei die Übertragungsschaltung (H1; H2, ...) und der Differenzverstärker (P11, P12; P21, P22), die in einem Verstärkungszweig enthalten sind, gemeinsam eine Gilbert-Zelle bilden.

3. Verstärkerschaltung nach Anspruch 1, wobei wenigstens ein Verstärkungszweig (D1, H1, A1; D2, H2, A2; ...) einen Spannungsteiler (D1; D2; ...) umfasst, der der Übertragungsschaltung (H1; H2, ...) vorgelagert angeordnet ist.

4. Vorrichtung (AF, AC, DET, PC) zum Empfangen von funkelektrischen Signalen, umfassend:
ein Antennensystem (AF) zum Empfangen eines solchen Signals und Transformieren des Signals in ein elektronisches Signal (Vin), gewöhnlich als Funksignal bezeichnet,
eine Verstärkerschaltung (AC) nach Anspruch 1 zum Liefern eines verstärkten Funksignals (Vout),
einen Leistungsdetektor (DET) zum Bereitstellen eines Steuersignals (CNT) für die Verstärkerschaltung, wobei das Steuersignal einen Vergleich zwischen dem Wert der Leistung des verstärkten Funksignals und einem Referenzwert repräsentiert, und
eine Signalverarbeitungskette (PC) zum Verarbeiten des verstärkten Funksignals.

## Revendications

1. Circuit d'amplification (AC) ayant un gain total (Gt) qui varie en continu en fonction de la valeur d'un signal de commande (CNT), circuit d'amplification qui comprend :
- une pluralité de branches d'amplification commandables(D1, H1, A1 ; D2, H2, A2 ; ..) couplées pour recevoir des signaux d'entrée identiques (Vin), chaque branche d'amplification commandable ayant un gain propre qui contribue au gain total, la taille de la contribution étant déterminée par le signal de commande,
- un additionneur (ADD) couplé pour recevoir les signaux de sortie respectifs issus des branches d'amplification,
**caractérisé en ce que** les branches d'amplification commandables comprennent chacun :
- un circuit de transfert (H1 ; H2, ..) pour produire un courant sur la base du signal d'entrée identique ;
- une paire différentielle (P11, P12 ; P21, P22) pour diriger le courant produit par le circuit de transfert vers une résistance de charge (RL) qui fait partie de l'additionneur, la paire différentielle ayant une conduction qui est commandée par une tension différentielle dérivée du signal de commande et appliquée aux bornes d'entrée (C1, C1n ; C2, C2n) de la paire différentielle.

2. Circuit d'amplification selon la revendication 1, dans lequel le circuit de transfert (H1 ; H2, ..) et la paire différentielle (P11, P12 ; P21, P22) compris dans une branche d'amplification constituent ensemble une cellule de Gilbert.

3. Circuit d'amplification selon la revendication 1, dans lequel au moins une branche d'amplification (D1, H1, A1 ; D2, H2, A2 ; ..) comprend un diviseur de tension (D1 ; D2 ; ..) situé en amont du circuit de transfert (H1 ; H2, ..).

4. Dispositif (AF, AC, DET, PC) pour recevoir des signaux radioélectriques, comprenant :
- un système d'antennes (AF) pour recevoir un tel signal et transformer le signal en un signal électronique (Vin), habituellement appelé signal radio,
- un circuit d'amplification (AC) selon la revendication 1, pour fournir un signal radio amplifié (Vout),
- un détecteur de puissance (DET) pour fournir un signal de commande (CNT) au circuit d'amplification, ce signal de commande est représentatif d'une comparaison entre la valeur de la puissance du signal radio amplifiée et une valeur de référence, et
- une chaîne de traitement du signal (PC) pour traiter le signal radio amplifié.
